# EUROPÄISCHE PATENTSCHRIFT

(11) **EP 2 473 649 B1**
(45) Veröffentlichungstag und Bekanntmachung des Hinweises auf die Patenterteilung: **06.05.2020**
(21) Anmeldenummer: 10745179.1
(22) Anmeldetag: 19.08.2010
(51) Int. Cl.: C23C 16/455, C23C 16/40, C23C 16/448

(54) **VERFAHREN ZUM AUFBRINGEN VON SCHICHTEN**
METHOD FOR APPLYING LAYERS
PROCÉDÉ POUR APPLIQUER DES COUCHES

(30) Priorität: 04.09.2009 DE 102009040165
(43) Veröffentlichungstag der Anmeldung: 11.07.2012
(73) Patentinhaber: Wieland-Werke AG, 89079 Ulm (DE)
(72) Erfinder: MERKEL, Till, 89231 Neu-Ulm (DE); LEHNERT, Christian, 89077 Ulm (DE)
(86) Internationale Anmeldenummer: PCT/EP2010/005080
(87) Internationale Veröffentlichungsnummer: WO 2011/026565

(56) Entgegenhaltungen:
- JP-A- 2006 040 936
- US-A- 5 360 646
- US-A- 5 470 800
- US-A- 5 840 631

## Beschreibung

Die Erfindung betrifft ein Verfahren zum Aufbringen von Schichten nach dem Oberbegriff des Anspruchs 1.

Verfahren zur Abscheidung fester Phasen durch eine chemische Reaktion einer als Precursor bezeichneten Vorläufersubstanz in einer Beschichtungskammer sind zur Beschichtung von Werkzeugen aus Metall mit Hartstoffbeschichtungen weit verbreitet. Halbmetalle und Keramiken für die Halbleiterherstellung oder für die Photovoltaik werden beispielsweise mit Oxidkeramiken wie SiO₂ beschichtet. Derartige Verfahren arbeiten typischerweise bei reduziertem Druck im Bereich 10⁻¹ bis 100 mbar. Es wird zwischen Hochtemperatur- (Temperaturen über 900 °C) und Mitteltemperaturverfahren (Temperaturen von 700 bis 900 °C) unterschieden.

Um dagegen bei Niedertemperaturverfahren (Raumtemperatur bis 500 °C) die erforderliche Energie zur Aktivierung chemischer Stoffumsetzungen in das System einzutragen, wird der Druck auf 10⁻¹ bis 10 mbar abgesenkt und häufig ein Plasma zum Energieeintrag eingekoppelt.

Als Vorläufersubstanzen für die Werkzeugbeschichtung werden beispielsweise Chloride des Siliziums, Titans oder Aluminiums in Niederdruckprozessen in die Gasphase überführt und in Hochtemperaturprozessen mit Stickstoff oder Sauerstoff zu Nitriden oder Oxiden umgesetzt. Zum Aufbringen von Oxidkeramiken, wie SiO₂ auf Silizium, kommen Hydride, Chloride oder siliziumorganische Verbindungen zum Einsatz, die bei Drücken unter 1 mbar und Temperaturen oberhalb 400 °C reagieren. Prozesstemperaturen knapp unter 400 °C sind möglich, wenn zusätzlich ein Plasma eingekoppelt wird. Eine Abscheidung von SiO₂, ausgehend von siliziumorganischen Verbindungen wie beispielsweise Tetraethylorthosilikat (TEOS) aus der Gasphase, kann in oxidativer Umgebung wie Sauerstoff oder Ozon auch bei Atmosphärendruck und Temperaturen von 420 bis 450 °C erfolgen. Die Abscheidung von ZrO₂ gelingt auch bei Atmosphärendruck und Temperaturen unter 400 °C in einer Hydrolysereaktion, wenn ein hydrolyseempfindlicher Precursor aus der Klasse der Alkyl-Alkoxy-Verbindungen wie Zirkoniumacethylacethonat eingesetzt wird.

Die Umsätze von Hydrolysereaktionen schwach hydrolyseanfälliger Precursoren wie Tetraalkoxy-Verbindungen (z.B. TEOS) sind nur bei hohen Temperaturen ausreichend für eine wirtschaftliche Prozessführung. Durch den Einsatz geeigneter Katalysatoren können beispielsweise bei der Reaktion von TEOS mit Wasser die Umsätze beschleunigt werden. Dies wird bei Sol-Gel-Prozessen in flüssiger Phase technisch genutzt. Aus einer Mischung von TEOS, Wasser und Katalysator in flüssiger Phase kann auch verdampft werden, um in einer dahinter angeordneten Beschichtungskammer SiO₂ abzuscheiden.

Derartige Schichten können genutzt werden, um Gegenstände vor Korrosion zu schützen, um allgemein eine Barriere gegen unerwünschte Diffusion aufzubauen und um optische Funktionen als Interferenzschichten auszuführen. Auch zum Zwecke der elektrischen Isolation sind Siliziumdioxid-Schichten angedacht und werden unter anderem verwandt, wenn bei elektronischen Bauelementen hohe Durchbruchsfeldstärken erreicht werden sollen.

So ist in diesem Zusammenhang aus der Druckschrift DE 10 2007 010 995 A1 ein Verfahren und eine Vorrichtungen zum Aufbringen von transparenten Siliziumdioxid-Schichten aus der Gasphase bekannt. Bei diesem Abscheideverfahren aus der Gasphase, bei welchem mittels eines Trägergases Precursoren in einen Ofen eingeleitet werden, wird dem Gasphasenprozess ein Flüssigphasenprozess vorgeschaltet. Als Flüssigphasenprozess wird ein Sol-Gel-Prozess aus siliziumhaltigen Ausgangschemikalien verwendet. Hierbei wird allerdings der Flüssigphasenprozess bereits im Sol-Stadium vorzeitig dadurch abgebrochen, indem aus dem Reaktionsgemisch die in der flüssigen Phase gebildeten Precursoren zur Beschichtung verdampft, mit dem Trägergas gemischt und zum Ofen transportiert werden. Polymerisationsreaktionen in der flüssigen Phase beeinflussen die Prozessstabilität. Die Zuleitungen zur Beschichtungskammer werden auf der Innenseite beschichtet, diese Beschichtungen platzen ab und werden als feste Partikel in die Beschichtungskammer eingetragen und dort auch auf den Oberflächen der zu beschichtenden Werkstücke abgelagert. Dies führt zur Bildung von Fehlstellen.

Eine andere Druckschrift US 6,022,812 beschreibt ein Verfahren, in dem ebenfalls flüssige und gasförmige Substanzen Verwendung finden. Dabei wird eine siliziumorganische Verbindung flüssig auf eine Oberfläche aufgezogen und dann einer Gasatmosphäre, bestehend aus Säuredampf und Wasserdampf, ausgesetzt. So lassen sich dünne Filme erzeugen, für größere Schichtdicken muss dieser Vorgang mehrfach wiederholt werden. Nach diesem Prinzip arbeiten auch die sogenannten Dip-coating-Prozesse.

Reine Gasphasenprozesse zur Beschichtung von Halbleitern in oxidierender Atmosphäre sind ebenfalls vorbekannt. In der Druckschrift US 5,840,631 wird ein zweischrittiger Prozess zur Abscheidung von SiO₂ bei 400°C beschrieben. Im ersten Schritt wird eine gasförmige siliziumorganische Verbindung mit Ozon und Wasserdampf zur Reaktion gebracht. Darüber wird eine zweite Lage der Beschichtung aufgebracht, deren Eigenschaften durch Einsatz eines Katalysators gesteuert werden. Das eingesetzte starke instabile Oxidationsmittel Ozon in Kombination mit brennbaren und explosionsfähigen Verbindungen, wie Tetraethylorthosilikat (TEOS), stellt hohe apparative Anforderungen. Das Prozessgas ist hochreaktiv und hat nach den angegebenen Volumenströmen eine Verweilzeit in der Nähe des zu beschichtenden Bauteils von wenigen Sekunden.

Ein einschrittiges Beschichtungsverfahren gemäß US 3,556,841, bei dem Essigsäure und Tetraethylorthosilikat in der Gasphase zur Reaktion gebracht werden, führt bei Temperaturen oberhalb 440 °C zu signifikanten Umsätzen. In einem anderen Verfahren gemäß US 5,360,646 werden drei reaktive Komponenten unmittelbar über dem zu beschichtenden Substrat gemischt und in einem Stickstoffträgergasstrom einmalig mit dem Substrat in Kontakt gebracht. Dabei läuft der Beschichtungsprozess bei 250 bis 350°C ab, wenn hohe Partialdrücke von Essigsäure und Wasser bei niedrigen TEOS-Gehalten eingestellt werden.

In der Druckschrift JP 2006 040936 A wird ein Beschichtungsverfahren beschreiben, bei dem als Prozessgas ein Gasgemisch verwendet wird, das einen siliciumhaltigen Precursor, Wasser, einen Katalysator und Ozon enthält. Die Verwendung von Ozon führt zu einer Beschleunigung der Schichtbildung, erfordert aber einen apparativen und stofflichen Mehraufwand. Die Vermischung der einzelnen Substanzen und der eigentliche Abscheidevorgang finden in voneinander getrennten Gasräumen statt.

Der Erfindung liegt die Aufgabe zugrunde, ein Niedertemperaturverfahren zum Aufbringen von Schichten auf Oberflächen von Metallen weiterzubilden, das mit einfacher Anlagentechnik die Beschichtung von komplexen Bauteilen in einem Arbeitsgang ermöglicht, nicht zu Gefügeveränderungen metallischer Werkstoffe führt und bei sparsamem Einsatz der Prozesschemikalien wirtschaftliche Abscheideraten realisiert.

Die Erfindung wird durch die Merkmale des Anspruchs 1 wiedergegeben. Die weiteren rückbezogenen Ansprüche betreffen vorteilhafte Aus- und Weiterbildungen der Erfindung.

Die Erfindung schließt ein Verfahren zum Aufbringen von Schichten aus keramischen oder organokeramischen Materialien auf Oberflächen von Metallen, Halbmetallen oder deren Verbindungen sowie aus diesen Materialien gefertigten Bauteilen oder Baugruppen durch einen chemischen Abscheideprozess aus der Gasphase bei Atmosphärendruck oder 30 % darunter und Prozesstemperaturen während der Abscheidung unterhalb 500 °C ein. Im Verfahren werden die zur Schichtbildung aus der Gasphase verwendeten reaktiven chemischen Substanzen aus mehreren Vorläufersubstanzen durch eine katalysierte Gasphasenreaktion gebildet. Die vorgelagerte katalysierte Gasphasenreaktion und der Abscheideprozess laufen in einem gemeinsamen Gasraum ab. Der Abscheideprozess wird in einem Arbeitsgang durchgeführt, wobei die reaktiven chemischen Substanzen und die Vorläufersubstanzen im gemeinsamen Gasraum homogen rückvermischt werden, und die mittlere Verweilzeit des Prozessgases als Verhältnis von Volumen des Gasraums und Gasdurchsatz mehr als 2 Minuten bei einer Abscheiderate von 10 bis 2000 nm pro Stunde beträgt.

Bevorzugte Abscheideraten liegen im Bereich von 50 bis 200 nm pro Stunde. Um die gewünschten Abscheideraten einzustellen, wird beispielsweise auf der Basis der Halbwertszeiten der gesamten Reaktionskette ein Gasdurchsatz ausgewählt, der eine ausreichende mittlere Verweilzeit zur Folge hat.

Keramische Materialien im Sinne der erfinderischen Lösung sind Materialien, deren chemische Zusammensetzung insbesondere der Zusammensetzung technischer Keramiken entspricht - diese Materialien können abhängig von den Prozessbedingungen nach dem Beschichtungsprozess in kristalliner, teilkristalliner Form, amorph oder als Gläser vorliegen. Sofern durch die Wahl geeigneter Precursoren organische Funktionalitäten in die keramischen Materialien eingebracht werden, werden diese als organo-keramische Materialien bezeichnet.

Bei der erfinderischen Lösung handelt es sich um ein neues Beschichtungsverfahren im Bereich der MOCVD (Metallorganischen-Gasphasenabscheidung), mit dem auch temperaturempfindliche Substrate beschichtet werden können.

Die Erfindung geht dabei von der Überlegung aus, dass mittels einer katalysierten Gasphasenreaktion keramische oder organo-keramische Materialien auf Metall, Halbmetalle oder deren Verbindungen, wie beispielsweise Legierungen, Oxide, Sulfide, Carbide etc., aufgebracht werden. Auch Bauteiloberflächen aus den vorstehend genannten Materialien kommen für eine Beschichtung in Betracht. Insbesondere Bauteile mit komplexer Geometrie der Oberflächen, wie beispielsweise Hohlräume, Hinterschneidungen, Innenräume etc., sind für eine Beschichtung mit dem beschriebenen Verfahren von besonderem Interesse. Hierbei können elektrische, magnetische, thermische, optische, tribologische, mechanische oder chemische Eigenschaften optimiert werden.

Der erfindungsgemäße Abscheideprozess findet komplett in der Gasphase statt. Hierbei reagieren die Vorläufersubstanzen (Precursoren) in der Gasphase miteinander, bilden dabei eine ebenfalls gasförmige intermediäre Substanz, die dann bei Temperaturen unterhalb von 500 °C zerfällt. Diese Zerfallsreaktion führt zur Bildung einer festen Schicht, wobei sich wirtschaftlich interessante Beschichtungsraten oberhalb 50 nm/min nur dann erreichen lassen, wenn höhere Konzentrationen der gasförmigen intermediären Substanz bereitgestellt werden können. Die Bildung dieser intermediären Substanz stellt den geschwindigkeitsbestimmenden Schritt des Gesamtprozesses dar. Beispielsweise sind die Precursoren eine siliziumorganische Verbindung wie TEOS, Wasser und ein Katalysator. Dieser Zerfall führt bei Temperaturen oberhalb von 250°C zum Aufbau einer fest haftenden dünnen Schicht auf der Oberfläche des Substrats. Als Substrat können Metalle wie Aluminium, Kupfer, Eisen oder deren Legierungen sowie Halbmetalle wie Silizium dienen. Diese Schichten können auch auf den Verbindungen der genannten Substrate, wie beispielsweise Oxiden oder Sulfiden, aufgebracht werden. Bei Einsatz des Precursors TEOS ist das feste Reaktionsprodukt eine SiO₂-Schicht.

Die erfindungsgemäßen Schichten können auf den angegebenen Materialien und Bauteilen im Bereich 1 bis 5000 nm, bevorzugt im Bereich zwischen 50 und 1000 nm, sogar mit Abscheideraten zwischen 500 und 5000 nm/h abgeschieden werden. Die Wirtschaftlichkeit ist durch den Einsatz verfügbarer Anlagentechnik und eigensicherer Chemikalien gegeben.

Der besondere Vorteil besteht darin, dass durch hohe Abscheideraten eine Beschichtung von Metallen und Halbleitern und komplexen Bauteilen sowie Hohlkörpern möglich ist, sofern hohe Konzentrationen der hochreaktiven intermediären Substanz realisiert werden können. Auch Abscheidungen auf komplexeren Keramiken im Gebiet der Photovoltaik oder auf Supraleitern oder beim Einsatz geeigneter Precursoren zum Aufbau komplexer Keramiken sind möglich.

Mittlere Verweilzeiten des Prozessgases im Gasraum sind größer als 2 min. Die mittleren Verweilzeiten können jedoch auch 10 min oder 20 min übersteigen. Letztendlich können sich die längeren Zeitspannen insbesondere im Falle einer Abscheidung bei geringeren Temperaturen ergeben. Bei geringeren Temperaturen wird der Stoffumsatz der Vorläufersubstanzen in die zur Schichtbildung aus der Gasphase verwendeten reaktiven chemischen Substanzen verlangsamt ablaufen. Insgesamt sinkt dann auch die Abscheiderate, wodurch, aufgrund des geringeren Gesamtumsatzes, eine längere mittlere Verweilzeit der rückvermischten Gasspezies im Gasraum festgelegt werden kann.

In bevorzugter Ausgestaltung der Erfindung kann die Prozesstemperatur während der Schichtbildung zwischen 100 und 450 °C gewählt werden. Das Abscheideverfahren ermöglicht so auch die Beschichtung von Kupferwerkstoffen als metallische Subrate, die bei Temperaturen oberhalb von 450 °C geglüht werden, um die mechanischen Kennwerte einzustellen, welche während der Schichtabscheidung aufgrund der niedrigen Prozesstemperaturen nicht geändert oder sogar beeinträchtigt werden.

Bei weiterer vorteilhafter Ausführungsform der Erfindung kann die Prozesstemperatur während der Schichtbildung zwischen 250 und 400 °C gewählt werden. Durch eine Absenkung der Temperatur im Reaktionsraum auf Werte unter 400 °C können auch Leichtmetalle wie Aluminium, die mit gängigen CVD-Verfahren aufgrund ihres niedrigen Schmelzpunkts bei Atmosphärendruck nicht beschichtet werden können, behandelt werden. Niedrige Temperaturen verlangsamen den geschwindigkeitsbestimmenden Schritt, der zur Bildung der hochreaktiven intermediären Verbindung führt, allerdings verlängert sich dadurch dessen Lebensdauer. Dies ist die Voraussetzung für die Beschichtung komplexer Teile, die vom Prozessgas zwangsweise umspült werden. Für die Precursorsubstanz TEOS ist beispielsweise eine Absenkung der Prozesstemperatur unterhalb von 250 °C aufgrund der durch die Reaktionskinetik bestimmten geringeren Abscheideraten nicht sinnvoll, wenn die Aktivierungsenergie für die chemische Reaktion ausschließlich über thermische Energie eingetragen wird. Eine Einkopplung der Aktivierungsenergie aus anderen Energiequellen wie beispielsweise einem Plasma würde eine weitere Temperaturabsenkung bei zufriedenstellender Abscheiderate erlauben.

Die Vorläufersubstanzen werden zur Bildung der reaktiven chemischen Substanzen in einer katalysierten Hydrolysereaktion umgesetzt. Als Vorläufersubstanzen sind insbesondere solche Verbindungen geeignet, die mit Wasser leicht zersetzt werden können. In diese Stoffklasse gehören unter anderem typische Precursoren für plasma-unterstützte CVD-Prozesse (PACVD oder PECVD) wie Hexamethyldisiloxan (HMDSO) oder die Tetraalkoxysilane wie TEOS. Im Vergleich zu den Alkyl-Alkoxy-Verbindungen wie HMDSO sind die Tetraalkoxysilane wie TEOS stabiler gegen eine thermische Zersetzung in der Beschichtungskammer. Daher gelingt eine wirtschaftliche Durchführung des erfindungsgemäßen Prozesses mit TEOS in einer Hydrolysereaktion nur mit Unterstützung eines Katalysators.

Des Weiteren werden die Vorläufersubstanzen in einer säure-katalysierten Hydrolysereaktion umgesetzt. Bei der Durchführung von Sol-Gel-Prozessen in flüssiger Phase macht man sich die katalytische Wirkung saurer oder alkalischer Zusätze zunutze. Bei Einsatz von Säuren wie Flusssäure, Salpetersäure, Schwefelsäure oder Essigsäure oder Laugen wie Natronlauge oder Ammoniak werden die Gelbildungszeiten als Maß für die Reaktionsgeschwindigkeit im Sol-Gel-Prozess deutlich verkürzt. Durch die Wahl eines geeigneten Katalysators anhand seiner Säure-/Basestärke können in der flüssigen Phase auch die nach der Gelbildung einsetzenden Kondensationsreaktionen beschleunigt oder verzögert werden. Durch Übertragung dieses Konzepts der säure- oder basekatalysierten Hydrolyse in die Gasphase können auch bei niedrigen Prozesstemperaturen unterhalb von 400°C hohe Beschichtungsraten realisiert werden, wenn die Partialdrücke von Katalysator und Wasserdampf und die Verweilzeit als Verhältnis von Volumenstrom des Prozessgases und Volumen des Reaktionsraums aufeinander abgestimmt werden. Die Verweilzeiten liegen oberhalb von 2 min, bevorzugt werden längere Verweilzeiten größer 20 min eingestellt.

Gemäß der Erfindung findet die katalysierte Gasphasenreaktion zur Erzeugung der zur Schichtbildung erforderlichen reaktiven chemischen Substanzen im gleichen Gasraum statt, in dem auch die Beschichtung der Oberfläche durchgeführt wird. Im Sinne einer wirtschaftlichen Prozessführung ist es sinnvoll, die chemischen Reaktionen, und zwar sowohl die zur Schichtbildung führende Zerfallsreaktion einer intermediären Substanz als auch die vorgelagerten Reaktionsschritte, beispielsweise im Falle der säurekatalysierten Hydrolyse von TEOS von der Protonierung bis zur Bildung des instabilen Intermediären, in einem Reaktionsraum zusammenzufassen. Dadurch wird insbesondere vermieden, dass es in Zuleitungen oder Mischungszonen außerhalb der Beschichtungskammer bereits zur Bildung fester Phasen auf den Oberflächen oder in der Gasphase kommt.

Alternativ ist es auch möglich, dass die katalysierte Gasphasenreaktion zur Erzeugung der zur Schichtbildung erforderlichen reaktiven chemischen Substanzen in einem vorgelagerten ersten Gasraum durchgeführt wird, aus dem die reaktiven chemischen Substanzen dann in einen zweiten Gasraum eingeleitet werden, in dem die Beschichtung der Oberfläche durchgeführt wird. Im Falle der säurekatalysierten Hydrolyse von Alkoxyverbindungen, wie beispielsweise TEOS, mit anschließender Zerfallsreaktion der intermediären Substanz gehen der eigentlichen Zerfallsreaktion mehrere Vorreaktionen voraus. Wegen der niedrigen Prozesstemperaturen ist die Geschwindigkeit des Gesamtprozesses durch die Kinetik der chemischen Reaktion begrenzt und damit reaktionskontrolliert. Mit dem Ziel einer optimierten Prozessführung kann es sinnvoll sein, die vorgelagerten Reaktionen unter kontrollierten Bedingungen bezüglich Temperatur- und Strömungsführung sowie Verweilzeit außerhalb der Beschichtungskammer ablaufen zu lassen. Zweckmäßig erfolgt dies beispielsweise in einem der Beschichtungskammer vorgeschalteten Reaktionsraum, der als beheizter Kapillarreaktor, Rohrreaktor mit Katalysatorschüttung oder immobilisertem Katalysator ausgeführt ist. Auf diese Weise kann ein weitgehend vollständiger Ablauf der vorgelagerten Reaktionen gewährleistet werden, so dass das in die Beschichtungskammer eintretende Gas einen hohen Anteil der hoch reaktiven intermediären Verbindung enthält, die dann in der Beschichtungskammer zerfällt. Auf diese Weise lassen sich Prozesszeiten wirksam verkürzen sowie Umsätze und Ausbeuten der eingesetzten Chemikalien optimieren.

Gemäß der Erfindung werden als Vorläufersubstanzen Alkoxy-, Carboxy- und/ oder nicht-, teil- oder vollsubstituierte Alkyl-Alkoxy- bzw. Alkyl-Carboxy-Verbindungen verwendet, wobei zur Bildung von Oxidkeramiken der Einsatz von Vorläufersubstanzen (Precursoren) notwendig ist, deren Zentralatom, wie beispielsweise Silizium, Titan, Aluminium oder Zirkonium, bereits weitgehend mit dem späteren Bindungspartner Sauerstoff umgeben ist. Beispiele für derartige Verbindungen sind die Alkoxyverbindungen des Siliziums wie das Tetraethoxysilan (TEOS) oder das Tetramethoxysilan (TMOS). Zur Einstellung bestimmter Eigenschaften der abgeschiedenen Schichten kann es sinnvoll sein, organische Funktionalitäten in die Schichten zu integrieren. Dies kann beispielsweise gelingen, indem die Zentralatome nicht vollständig von Alkoxyresten umgeben sind, sondern einzelne organische Reste nur von Alkylgruppen gebildet werden, wie beispielsweise bei Triethoxyethylsilan. Die Wirkung derartiger Funktionalitäten kann durch Variation der Kettenlänge dieser Alkylgruppen oder der vollständigen oder teilweisen Substitution der Wasserstoffatome in der Alkylgruppe durch Fremdatome, wie beispielsweise Fluor gesteuert werden. Analoge Betrachtungen gelten für den Einsatz von Carboxyverbindungen, wie beispielsweise Dihydroxy-Aluminium-Acetat.

Gemäß der Erfindung werden als Vorläufersubstanzen Alkoxy-, Carboxy- und/oder nicht-, teil- oder vollsubstituierte Alkyl-Alkoxy- bzw. Alkyl-Carboxy-Verbindungen mit Silizium, Aluminium, Titan oder Zirkon verwendet. Wichtige technische Anwendungsfelder für den Prozess sind die Abscheidung von Oxidkeramiken von Silizium, Aluminium, Titan oder Zirkon. Für diese Prozesse stehen geeignete Precursoren wie TEOS als siliziumorganische Verbindungen, Dihydroxy-Aluminium-Acetat und Aluminium-triethoxid als aluminiumorganische Verbindungen, Tetra-isopropoxid-Titan als titanorganische Verbindung oder Zirkoniumethoxid als zirkonorganische Verbindung zur Verfügung. Diese Betrachtungen lassen sich jedoch ebenso auf andere Oxidkeramiken auf der Basis von Yttrium oder Lanthan übertragen.

Die Wirtschaftlichkeit der Prozessführung wird vom Umsatz der chemischen Reaktion, dem Verbrauch an Einsatzchemikalien sowie der Langlebigkeit der Anlagen bestimmt. Durch die Realisierung längerer Verweilzeiten des Prozessgases im vollständig rückvermischten Gasraum werden die eingesetzten Chemikalien besser ausgenutzt und der Verbrauch an Katalysator und Wasser kann reduziert werden. So haben sich in einer bevorzugten Ausführung des Verfahrens molare Verhältnisse der Einsatzchemikalien TEOS, Essigsäure und Wasser von 1 : 1 bis 5 : 1 bis 5 bewährt, wenn diese mit längeren Verweilzeiten kombiniert werden. Durch den geringen Anteil an Essigsäure verringert sich der korrosive Angriff der Prozessgase auf Anlagenkomponeten deutlich und erhöht so deren Lebensdauer und damit Wirtschaftlichkeit des Prozesses.

Vorteilhafterweise können die eingesetzten Vorläufersubstanzen bei Raumtemperatur weitgehend stabil, transport- und lagerfähig sein und keine explosionsfähigen Gemische mit Luft bilden. Atmosphärische CVD-Prozesse haben wegen der gegenüber den vakuumbasierten Verfahren höheren Prozessdrücke häufig einen höheren Gasdurchsatz. Die erzeugten Prozessabgase müssen daher mit geringem technischem und insbesondere sicherheitstechnischem Aufwand entsorgt werden können. Ein erhöhter Verbrauch bedingt auch eine größere Bevorratung der Vorläufersubstanzen. Dabei werden an die Ver- und Entsorgung hohe Sicherheits- und Umweltanforderungen gestellt. Eine Variante des erfindungsgemäßen Prozesses mit den Vorläufersubstanzen TEOS, Essigsäure und Wasser hat sich dabei als besonders günstig erwiesen. Diese Substanzen sind bei der Lagerung bei Raumtemperatur weitgehend stabil und bilden mit Luft keine explosionsfähigen Gemische. Die Prozessabgase werden als Flüssigkeit aus dem Abgas quantitativ abgeschieden und können nach Ablauf der Kondensationsreaktion als feste Abfälle preiswert entsorgt werden. Aufwändige Gasreinigungsverfahren wie Brenner, Wäscher oder Absorberpatronen können auf diese Weise entfallen.

Bei einem besonders vorteilhaften Ausführungsbeispiel im Zuge einer Umsetzung des erfindungsgemäßen Abscheideprozesses wurde insbesondere auch TEOS und Wasser mit dem Katalysator Essigsäure separat verdampft und in der Gasphase miteinander zur Reaktion gebracht. In einer über mehrere Schritte ablaufenden Reaktion (Protonierung, nucleophiler Angriff, Bildung eines instabilen Intermediären wie z.B. einem Silanol) wurde dann in der Beschichtungskammer SiO₂ abgeschieden. Bei Verdopplung des Wasseranteils in der Gasphase konnten Abscheideraten über 2000 nm/h realisiert werden. Bei Verdampfung aus einem Sol der genannten Substanzen und anschließender Einleitung in eine Beschichtungskammer würden lediglich Abscheideraten im Bereich 100 nm/h erzielt.

## Patentansprüche

1. Verfahren zum Aufbringen von Schichten aus keramischen oder organokeramischen Materialien auf Oberflächen von Metallen, Halbmetallen oder deren Verbindungen sowie aus diesen Materialien gefertigten Bauteilen oder Baugruppen durch einen chemischen Abscheideprozess aus der Gasphase bei Atmosphärendruck oder 30 % darunter und Prozesstemperaturen während der Abscheidung unterhalb 500 °C, wobei die zur Schichtbildung aus der Gasphase verwendeten reaktiven chemischen Substanzen aus den Vorläufersubstanzen Alkoxy-, Carboxy- und/oder nicht-, teil- oder vollsubstituierte Alkyl-Alkoxy- bzw. Alkyl-Carboxy-Verbindungen mit Silizium, Aluminium, Titan oder Zirkon unter Zugabe von Wasser und einer Säure durch eine katalysierte Gasphasenreaktion gebildet werden,
**dadurch gekennzeichnet,**
- **dass** die vorgelagerte katalysierte Gasphasenreaktion und der ablaufende Abscheideprozess in einem gemeinsamen Gasraum ablaufen,
- **dass** der Abscheideprozess in einem Arbeitsgang durchgeführt wird,
- **dass** die reaktiven chemischen Substanzen und die Vorläufersubstanzen im gemeinsamen Gasraum homogen rückvermischt werden und
- **dass** die mittlere Verweilzeit des Prozessgases als Verhältnis von Volumen des Gasraums und Gasdurchsatz mehr als 2 min bei einer Abscheiderate von 10 bis 2000 nm pro Stunde beträgt.

2. Verfahren nach Anspruch 1 **dadurch gekennzeichnet, dass** die mittlere Verweilzeit des Prozessgases im vollständig rückvermischten Gasraum größer als 10 min ist.

3. Verfahren nach Anspruch 1 **dadurch gekennzeichnet, dass** die mittlere Verweilzeit des Prozessgases im vollständig rückvermischten Gasraum größer als 20 min ist.

4. Verfahren nach einem der Ansprüche 1 bis 3, **dadurch gekennzeichnet, dass** die Prozesstemperatur während der Schichtbildung zwischen 100 und 450 °C gewählt wird.

5. Verfahren nach Anspruch 4, **dadurch gekennzeichnet, dass** die Prozesstemperatur während der Schichtbildung zwischen 250 und 400 °C gewählt wird.

6. Verfahren nach einem der Ansprüche 1 bis 5, **dadurch gekennzeichnet, dass** die katalysierte Gasphasenreaktion zur Erzeugung der zur Schichtbildung erforderlichen reaktiven chemischen Substanzen im gleichen Gasraum stattfindet, in dem auch die Beschichtung der Oberfläche durchgeführt wird.

7. Verfahren nach einem der Ansprüche 1 bis 6, **dadurch gekennzeichnet, dass** als Vorläufersubstanzen TEOS, Essigsäure und Wasser im molaren Verhältnis 1 : 1 bis 5 : 1 bis 5 verwendet werden.

## Claims

1. Method for applying layers of ceramic or organoceramic materials to surfaces of metals, semi-metals or the compounds thereof and components or sub-assemblies produced from these materials by means of a chemical deposition process from the gas phase at atmospheric pressure or 30% below and process temperatures during the deposition below 500°C, wherein the reactive chemical substances used for layer formation from the gas phase are formed from the precursor substances alkoxy, carboxy and/or non-substituted, partially or completely substituted alkyl-alkoxy or alkyl-carboxy compounds with silicon, aluminium, titanium or zirconium with the addition of water and an acid by means of a catalysed gas phase reaction,
**characterised in that**
- the upstream catalysed gas phase reaction and the current deposition process take place in a common gas chamber,
- **in that** the deposition process is carried out in one operating step,
- **in that** the reactive chemical substances and the precursor substances are back-mixed in a homogeneous manner in the common gas chamber and
- **in that** the mean dwell time of the process gas as a ratio of volume of the gas chamber and gas throughput is more than 2 minutes at a deposition rate of from 10 to 2000 nm per hour.

2. Method according to claim 1, **characterised in that** the mean dwell time of the process gas in the completely back-mixed gas chamber is greater than 10 minutes.

3. Method according to claim 1, **characterised in that** the mean dwell time of the process gas in the completely back-mixed gas chamber is greater than 20 minutes.

4. Method according to any one of claims 1 to 3, **characterised in that** the process temperature during the layer formation is selected to be between 100 and 450°C.

5. Method according to claim 4, **characterised in that** the process temperature during the layer formation is selected to be between 250 and 400°C.

6. Method according to any one of claims 1 to 5, **characterised in that** the catalysed gas phase reaction for producing the reactive chemical substances required for layer formation takes place in the same gas chamber in which the coating of the surface is also carried out.

7. Method according to any one of claims 1 to 6, **characterised in that** TEOS, acetic acid and water are used as precursor substances in the molar ratio 1:1 to 5:1 to 5.

## Revendications

1. Procédé pour appliquer des couches de matériaux céramiques ou organocéramiques sur des surfaces de métaux, semi-métaux ou leurs composés ainsi que d'éléments structuraux ou d'ensembles structuraux produits à partir de ces matériaux par un processus de dépôt chimique en phase gazeuse à la pression atmosphérique ou 30 % en-dessous et des températures de processus pendant le dépôt en-dessous de 500°C, où les substances chimiques réactives utilisées pour la formation de couches en phase gazeuse sont formées à partir des substances progénitrices composés alcoxy, carboxy et/ou alkyl-alcoxy ou alkyl-carboxy non substitués, partiellement substitués ou totalement substitués avec le silicium, l'aluminium, le titane ou le zirconium avec addition d'eau et d'un acide par une réaction en phase gazeuse catalysée,
**caractérisé**
- **en ce que** la réaction en phase gazeuse catalysée préalable et le processus de dépôt qui se déroule se déroulent dans un espace de gaz commun,
- **en ce que** le processus de dépôt est réalisé dans une étape opératoire,
- **en ce que** les substances chimiques réactives et les substances progénitrices sont remélangées de manière homogène dans l'espace de gaz commun et
- **en ce que** le temps de séjour moyen du gaz de processus sous forme de rapport du volume de l'espace de gaz et du débit de gaz est supérieur à 2 min à une vitesse de dépôt de 10 à 2000 nm par heure.

2. Procédé selon la revendication 1 **caractérisé en ce que** le temps de séjour moyen du gaz de processus dans l'espace de gaz totalement remélangé est supérieur à 10 min.

3. Procédé selon la revendication 1 **caractérisé en ce que** le temps de séjour moyen du gaz de processus dans l'espace de gaz totalement remélangé est supérieur à 20 min.

4. Procédé selon l'une des revendications 1 à 3, **caractérisé en ce que** la température de processus pendant la formation de couches est choisie entre 100 et 450°C.

5. Procédé selon la revendication 4, **caractérisé en ce que** la température de processus pendant la formation de couches est choisie entre 250 et 400°C.

6. Procédé selon l'une des revendications 1 à 5, **caractérisé en ce que** la réaction en phase gazeuse catalysée pour la production des substances chimiques réactives nécessaires pour la formation de couches a lieu dans le même espace de gaz que celui dans lequel le revêtement de la surface est réalisé.

7. Procédé selon l'une des revendications 1 à 6, **caractérisé en ce que** TEOS, l'acide acétique et l'eau sont utilisés comme substances progénitrices dans le rapport molaire 1:1 à 5:1 à 5.
